# EUROPEAN PATENT APPLICATION

(11) **EP 4 746 290 A1**
(43) Date of publication of application: **20.05.2026**
(21) Application number: 25213286.5
(22) Date of filing: 04.11.2025
(51) Int. Cl.: H03G 3/30, H03G 3/32

(54) **SYSTEM AND METHOD FOR EXTERNAL MICROPHONE AUTOMATIC SPEED-DEPENDENT TUNING FOR EXTERNAL AMBIENCE**

(30) Priority: 13.11.2024 US 202418946250
(71) Applicant: Harman International Industries, Incorporated, Stamford, Connecticut 06901 (US)
(72) Inventor: WINTON, Riley, Opelika, AL, 36804 (US); WILLIS, Maxwell B., Detroit, MI, 48201 (US); SCHMIDT, Skyler L., Detroit, MI, 48208 (US); GOMEZ, Antonio, Hazel Park, MI, 48030 (US); LUDWIG, Chris, Bloomfield Hills, MI, 48304 (US)
(74) Representative: Kraus & Lederer PartGmbB

(57) **Abstract**

In at least one embodiment, an audio system is provided. The audio system includes one or more microphones and at least one controller. The one or more microphones are positioned about a vehicle to provide a captured audio input signal. The at least one controller is programmed to receive the captured audio input signal and to receive a first signal indicative of a vehicle speed for the vehicle. The at least one controller is further programmed to determine an attenuation amount based on the vehicle speed for the vehicle and to attenuate the captured audio input signal based on the attenuation amount to increase clarity of the captured audio input signal.

## Description

### TECHNICAL FIELD

Aspects disclosed herein generally relate to a system and method for external microphone automatic speed-dependent tuning for external ambience in a vehicle. These aspects and others will be discussed in more detail herein.

### BACKGROUND

Automotive applications generally utilize one or more microphones positioned on an exterior section of the vehicle to detect ambient noise external to the vehicle. In some cases, the detection of externally based audio may be used for autonomous vehicles (AVs). In other cases, the detection of such externally based audio may be used for active noise cancellation (ANC) applications to reduce or mitigate such externally based noise from being heard in the vehicle in an effort to increase the listening experience provided by an audio system within the vehicle. However, as the vehicle increases in speed, the externally based microphones capture increased wind noise or other disturbances which may adversely impact the clarity of captured external audio.

### SUMMARY

In at least one embodiment, an audio system is provided. The audio system includes one or more microphones and at least one controller. The one or more microphones are positioned about a vehicle to provide a captured audio input signal. The at least one controller is programmed to receive the captured audio input signal and to receive a first signal indicative of a vehicle speed for the vehicle. The at least one controller is further programmed to determine an attenuation amount based on the vehicle speed for the vehicle and to attenuate the captured audio input signal based on the attenuation amount to increase clarity of the captured audio input signal.

In at least another embodiment, an audio system is provided. The audio system includes one or more microphones and at least one controller. The one or more microphones are positioned about a vehicle to provide a captured audio input signal. The at least one controller is programmed to receive the captured audio input signal and to receive a first signal indicative of a vehicle speed for the vehicle The at least one controller is further programmed to determine a cutoff frequency based on the vehicle speed for the vehicle and to apply the cutoff frequency to one or more filters to attenuate the captured audio input signal.

In at least another embodiment, a computer-program product embodied in a non-transitory computer read-able medium that is programmed and executable by one or more controllers to attenuate audio in a vehicle. The computer-program product comprising instructions for receiving a captured audio input signal from one or more microphones positioned about the vehicle and for receiving a first signal indicative of a vehicle speed for the vehicle. The computer-program product comprising instructions for performing one or more of: attenuating the captured audio input signal based on an attenuation amount to increase clarity of the captured audio input signal after determining the attenuation amount based on the vehicle speed for the vehicle and applying a cutoff frequency to one or more filters to attenuate the captured audio input signal after determining the cutoff frequency based on the vehicle speed for the vehicle.

### BRIEF DESCRIPTION OF THE DRAWINGS

The embodiments of the present disclosure are pointed out with particularity in the appended claims. However, other features of the various embodiments will become more apparent and will be best understood by referring to the following detailed description in conjunction with the accompany drawings in which:
FIGURE 1 generally depicts a system for attenuating a captured audio input signal provided by one or more microphones in accordance with one embodiment;
FIGURE 2 generally depicts a plot illustrating a speed-dependent microphone gain that is applied to the captured audio input signal in accordance with one embodiment;
FIGURE 3 generally depicts a method for adjusting a frequency for a filter to filter the captured audio input signal provided by the one or more microphones in accordance with one embodiment; and
FIGURE 4 generally depicts a method for attenuating the captured audio input signal provided by the one or more microphones in accordance with one embodiment.

### DETAILED DESCRIPTION

As required, detailed embodiments of the present invention are disclosed herein; however, it is to be understood that the disclosed embodiments are merely exemplary of the invention that may be embodied in various and alternative forms. The figures are not necessarily to scale; some features may be exaggerated or minimized to show details of particular components. Therefore, specific structural and functional details disclosed herein are not to be interpreted as limiting, but merely as a representative basis for teaching one skilled in the art to variously employ the present invention.

In one example, external microphones may be mounted on various exterior sections of a vehicle. The externally mounted microphones may be used to pick up or sense environmental sounds such as traffic noise, speech, wildlife, or others. In various implementations, vehicles may utilize the captured audio provided by microphones to notify the driver of sounds external to the vehicle as an extra sensory aspect. For example, it is possible for occupants in the vehicle to detect pedestrians proximate to the vehicle (e.g., children playing close to the vehicle), sirens of approaching vehicle, road conditions (e.g., water splashing and slipping on ice), etc. The driver may react to such detected audio accordingly to keep not only the driver and occupants safe but to keep pedestrians and others in surrounding vehicles safe.

When the vehicle is parked (i.e., in a static state) or traveling below a predetermined speed limit, the captured microphone signals are clear and useful. However, while driving above a certain speed limit, the wind noise may become a detrimental. Particularly in moments in which the vehicle travels at certain driving speeds. One proposed solution may include applying a speed-dependent tuning curve that attenuates the signals provided by the microphone(s) as the vehicle speed increases. This aspect may allow for environmental awareness and safety without a distracting or poor user experience at high speeds.

In general, it is desirable to improve external environmental awareness for safety and entertainment/user experience reasons. Conventional methods may utilize user controls to turn microphones on or off. This aspect creates a user burden. Conversely, by leaving microphone on all of the time causes a sub-optimal user experience while driving at higher speeds as the signal captured by the microphone is primarily wind and road noise. The embodiments disclosed herein automates the relationship between environmental awareness at low speeds and gradually fades undesired noise captured by the microphone as vehicle speed increases. The end result may include less user burden, a lighter user interface design, and an overall improved awareness for safety and entertainment purposes.

The disclosed tuning curve may be vehicle and microphone dependent and may be flexibly implemented as a lookup table or a dynamic tuning curve. Some embodiments may include a basic gain block that is integrated into the lookup table. However, other embodiments may involve multiband compression or dynamic equalization in order to perfect the microphone signal at given speeds. These aspects and others will be discussed in more detail below.

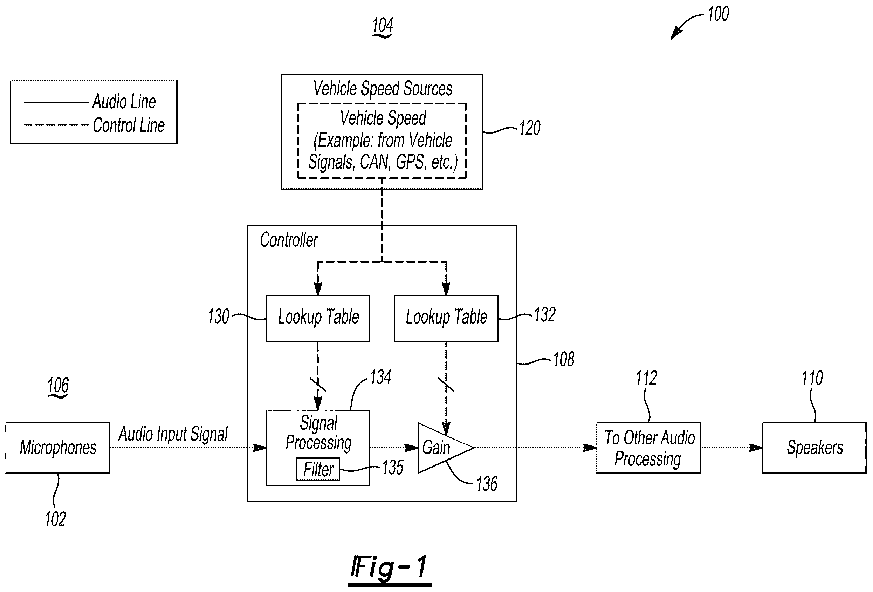

FIGURE 1 generally depicts a system 100 (or audio system 100) for attenuating a captured audio input signal provided by one or more microphones 102 positioned about a vehicle 104 in accordance with one embodiment. The microphones 102 may be positioned on external portions 106 of the vehicle 104 to capture audio from external to the vehicle 104. It is recognized that the number of microphones 102 positioned on the external portions 106 may vary based on the desired criteria of a particular implementation. The external portions 106 may include a chassis, engine compartment, trunk compartment, front/rear bumpers, etc. of the vehicle 104. In general, the microphones 102 may capture environmental sounds that are external to the vehicle 104 such as traffic noise, speech, wildlife, or others. Each of the microphones 102 generate an audio input signal that is indicative of the environment sounds.

The system 100 includes at least one controller 108 (hereafter "the controller 108") for receiving the audio input signal from each of the microphones 102 positioned in the vehicle 104. The controller 108 may be operably coupled to one or more loudspeakers 110 positioned in the vehicle 104. The controller 108 may transmit an audio output signal to the loudspeakers 110 to playback the captured audio external to the vehicle 104. In general, the system 100 may utilize the captured audio provided by microphones 102 to notify a driver of sounds external to the vehicle as an extra sensory aspect. For example, it is possible for occupants in the vehicle 104 to detect pedestrians proximate to the vehicle (e.g., children playing close to the vehicle), sirens of an approaching vehicle, road conditions (e.g., water splashing and slipping on ice), etc. The driver can react to such detected audio accordingly to keep not only the driver and occupants safe but to keep pedestrians and others in surrounding vehicles safe. An audio processing unit 112 is provided to process the audio output signal provided by the controller 108 prior to the audio output signal being provided to the loudspeakers 110.

It is also recognized that the system 100 may perform active noise cancellation based on the captured audio external to the vehicle 104. For example, in this case, the audio processing unit 112 may attempt to cancel the captured audio external to the vehicle 104 so as to enable the driver and/or occupants in the vehicle 104 to have an increased listening experience with respect to entertainment audio being played back by one or more of the loudspeakers 110 in the vehicle 104. In general, the system 100 reproduces the external sound that is captured via the one or more microphones 102 for playback in the vehicle 104. In some cases, the system 100 may play back the captured external sound along with desired audio provided by an entertainment device (i.e., audio controller, audio head unit, etc.) If the captured audio signal from the microphone 102 includes wind and/or road noise, then the listening experience for the occupant may be diminished.

A plurality of vehicle speed sources 120 is operably coupled to the controller 108 to provide a vehicle speed signal indicative of the speed at which the vehicle 104 is traveling. The plurality of vehicle speed sources 120 may include vehicle speed sensors (not shown), one or more vehicle speed controllers (now shown), and a navigation system (not shown). For example, the vehicle speed sensors may be operably coupled to one or more axles or wheels of the vehicle 104 and provide a raw vehicle speed signal that is indicative of the speed at which the vehicle is traveling. The vehicle speed sensors may transmit the raw speed signal either directly to the controller 108 or to one or more vehicle speed controllers to process the raw vehicle speed signal. In the event the vehicle speed sensors provide the raw speed signal to the vehicle speed controllers, the vehicle speed controllers may transmit a digital signal over a communication data bus to the controller 108. In one example, the digital communication bus may be but not limited to a Controller Area Network (CAN) bus. In addition, the navigation controller may also provide global position satellite (GPS) signals over the digital communication bus which at least indicate the vehicle speed of the vehicle 104 in addition to position coordinates of the vehicle 104. In this regard, the controller 108 may not be concerned with the position coordinates of the vehicle 104. Rather, the controller 108 utilizes the vehicle speed information to determine the amount of attenuation to apply to the captured audio external to the vehicle 104.

The controller 108 includes a first lookup table (LUT) 130, a second LUT 132, a signal processing block 134, and a gain block 136. In general, the controller 108 receives the vehicle speed signal to determine the current speed at which the vehicle 104 is traveling. The controller 108 also receives the captured audio input signal that is indicative of the environment sounds or the captured audio external to the vehicle 104. In general, as vehicle speed increases (or exceeds a predetermined vehicle speed), the captured audio input signal as provided by one or more of the microphones 102 exhibit additional wind noise or other disturbances. In this case, it is desirable to attenuate the captured audio signal prior to providing such a signal (or prior to providing the captured audio external to the vehicle 104) to the audio processing unit 112 and additionally to the one or more loudspeakers 110.

For example, it is generally desirable to reduce the amount of disturbance (e.g., wind noise) present on the captured audio input signal when the vehicle speed exceeds the predetermined vehicle speed. In this regard, the signal processing block 134 may correlate the received vehicle speed to a corresponding attenuation amount. In addition, it may be desirable to adjust a cutoff frequency of at least one filter 135 positioned within the signal processing block 134 based on the vehicle speed. For example, in the event the vehicle speed begins to increase, the controller 108 may reduce the cutoff frequency for the filter 135 to reduce or mitigate the impact of the road and/or wind noise heard by the occupants in the vehicle 104. In one example, assuming that the vehicle speed is equal to 20 mph, then the first LUT 130 may provide a cutoff frequency of 20 kHz to the filter 135. Further, for example, assuming that the vehicle speed is equal to 60 mph, then the first LUT 130 may provide a cutoff frequency of 1 kHz to the filter 135 to limit the noise at a much greater rate than that of when the vehicle speed is equal to 20 mph. The first LUT 130 may include a plurality of vehicle speed values that are associated with various cutoff frequencies. In this regard, the first LUT 130 may provide a corresponding cutoff frequency to the filter 135 based on the vehicle speed information provided by any one or more of the vehicle speed sources 120.

Turning back to the attenuation aspect, the signal processing block 134 may control the gain block 136 to attenuate (or reduce the gain of) the captured audio external signal (or the captured audio input signal) to the vehicle 104 at the corresponding attenuation level that matches the vehicle speed as set forth in the second LUT 132. For example, the second LUT 132 may include a plurality of vehicle speed values that are associated with various gain levels. In this regard, the second LUT 132 may provide a corresponding attenuation level (or volume/gain level) to the gain block 136 based on the vehicle speed information provided any one or more of the vehicle speed sources 120. It is recognized that the controller 108 may utilized one or more of the first LUT 130 and the second LUT 132 to reduce (attenuate) the noise on the captured audio input signal provided by the microphone 102. For example, the controller 108 may adjust the cutoff frequency of the filter 135 of the signal processing block 134 and/or adjust the gain of the gain block 136 based on the vehicle speed. It is recognized that the system 100 may utilize the first LUT 130 and the implementation of adjusting the cutoff frequency for the filter 135 and/or the second LUT 132 and the implementation of utilizing the attenuation level (e.g., volume/gain level) to attenuate the captured audio input signal.

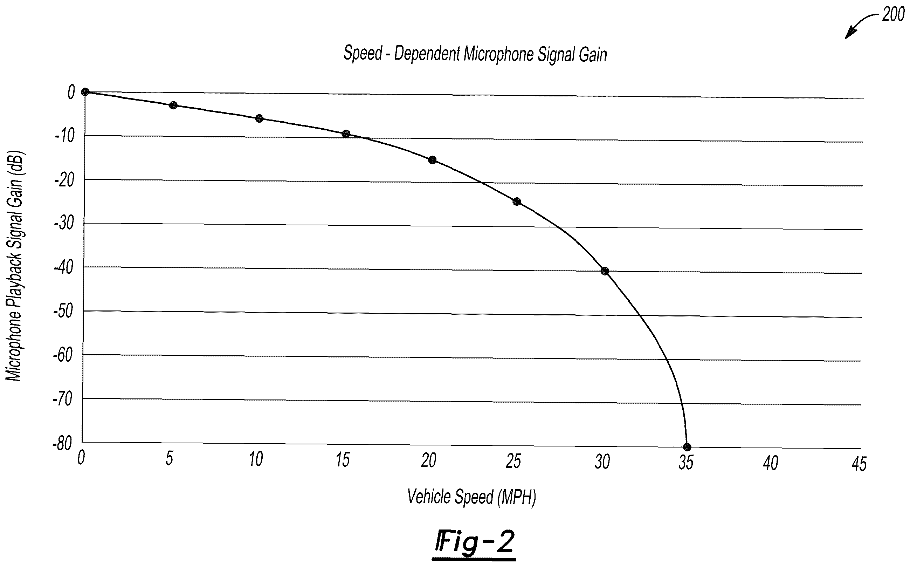

FIGURE 2 generally depicts a plot 200 that illustrates corresponding gain values to be applied to the captured audio input signal (e.g., see y -axis) and corresponding vehicle speeds received at the controller 108 (e.g., see x-axis) in accordance with one embodiment. As shown, for example, in the plot 200, once vehicle speed exceeds 15 mph, there is rapid increase in the amount of attenuation (or rapid decrease in gain) that is applied to captured audio signal to suppress the wind noise and/or other disturbances that are present on the captured audio input signal as provided by the microphones 102. In this regard, by attenuating or reducing the gain of the captured audio input signal based on the vehicle speed, the controller 108 provides the audio output signal to the audio processing unit 112 in which the audio processing unit 112 may further process with a clearer representation of the captured external audio for playback by the loudspeakers 110. Additionally or alternatively, by adjusting the cutoff frequency for the filter 135 of the signal processing block 134, the controller provides the audio output signal to the audio processing unit 112 in which the audio processing unit 112 may further process with a clearer representation of the captured external audio for playback by the loudspeakers 110. Similarly, these aspects improve the overall listening experience for the occupant(s) in the vehicle 104 as the playback of the captured audio signal may be reduced or disabled in moments in which the vehicle 104 experiences high speeds to enable the system to play entertainment audio for the occupant(s) in a clearer fashion.

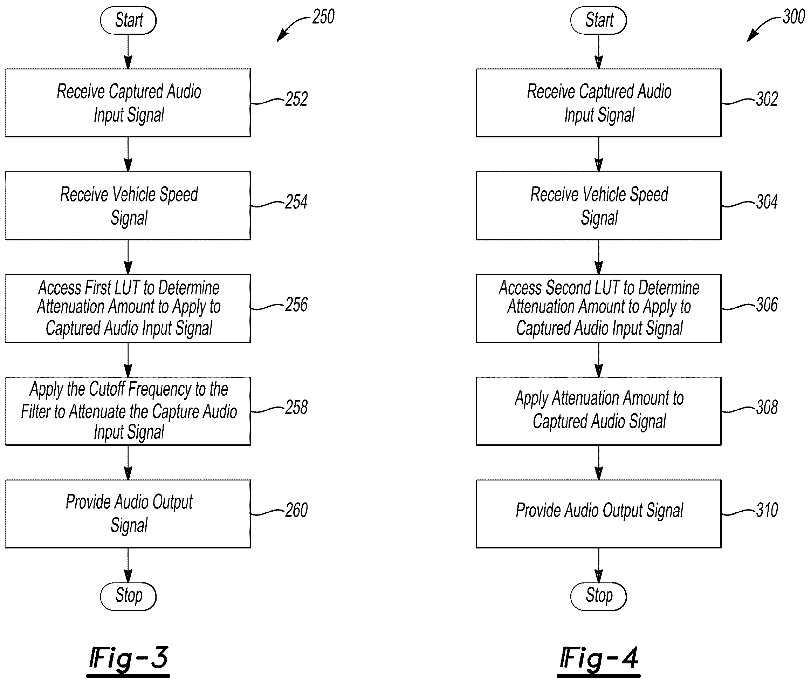

FIGURE 3 generally depicts a method 250 for adjusting a frequency for the filter 135 to filter the captured audio input signal provided by the one or more microphones 102 in accordance with one embodiment.

In operation 252, the controller 108 receives the captured audio input signal from each of the microphones 102.

In operation 254, the controller 108 receives the vehicle speed signal from one or more of the plurality of vehicle speed sources 120.

In operation 256, the controller 108 accesses the first LUT 130 to locate the corresponding vehicle speed and associated cutoff frequency for the filter 135 of the signal processing block 134.

In operation 258, the controller 108 applies the associated cutoff frequency to the filter 135 to the captured audio input signal to attenuate the captured audio input signal.

In operation 260, the controller 108 provides the audio output signal to at least one of the loudspeakers 110 or the audio processing unit 112.

FIGURE 4 generally depicts a method 300 for attenuating the captured audio input signal provided by the one or more microphones 102 in accordance with one embodiment.

In operation 302, the controller 108 receives the captured audio input signal from each of the microphones 102.

In operation 304, the controller 108 receives the vehicle speed signal from one or more of the plurality of vehicle speed sources 120.

In operation 306, the controller 108 accesses the second LUT 132 to locate the corresponding vehicle speed and associated attenuation level.

In operation 308, the controller 108 applies the associated attenuation level to the captured audio input signal.

In operation 310, the controller 108 provides the audio output signal to at least one of the loudspeakers 110 or the audio processing unit 112.

It is recognized that the controllers as disclosed herein may include various microprocessors, integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, such controllers as disclosed utilizes one or more microprocessors to execute a computer-program that is embodied in a non-transitory computer readable medium that is programmed to perform any number of the functions as disclosed. Further, the controller(s) as provided herein includes a housing and the various number of microprocessors, integrated circuits, and memory devices ((e.g., FLASH, random access memory (RAM), read only memory (ROM), electrically programmable read only memory (EPROM), electrically erasable programmable read only memory (EEPROM)) positioned within the housing. The controller(s) as disclosed also include hardware-based inputs and outputs for receiving and transmitting data, respectively from and to other hardware-based devices as discussed herein.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

## Claims

1. An audio system comprising:
one or more microphones for being positioned about a vehicle to provide a captured audio input signal; and
at least one controller being programmed to:
receive the captured audio input signal;
receive a first signal indicative of a vehicle speed for the vehicle;
determine an attenuation amount based on the vehicle speed for the vehicle; and
attenuate the captured audio input signal based on the attenuation amount to increase clarity of the captured audio input signal.

2. The audio system of claim 1, wherein the one or more microphones are positioned in at least one of an engine compartment, a trunk compartment, a chassis, and one or more of a front bumper and a rear bumper.

3. The audio system of claim 1 or 2, wherein the captured audio input signal corresponds to a captured audio signal that is external to the vehicle.

4. The audio system of any preceding claim, wherein the at least one controller includes a look up table (LUT) that includes a plurality of vehicle speeds and a plurality of attenuation amounts, wherein each of the plurality of vehicle speeds has an associated attenuation amount from the plurality of attenuation amounts.

5. The audio system of any preceding claim, wherein the at least one controller includes a gain block configured to have a gain adjusted thereof to attenuate the captured audio input signal.

6. The audio system of any preceding claim, wherein the at least one controller is further programmed to at least one of the following:
- transmit an audio output signal corresponding to the attenuated captured audio input signal to one or more loudspeakers positioned in the vehicle,
- determine a cutoff frequency based on the vehicle speed for the vehicle.
- apply the cutoff frequency to one or more filters to filter the captured audio input signal, and preferably
the at least one controller includes a look up table (LUT) that includes a plurality of vehicle speeds and a plurality of cutoff frequencies, wherein each of the plurality of vehicle speeds has an associated cutoff frequency to be applied to the one or more filters.

7. An audio system comprising:
one or more microphones for being positioned about a vehicle to provide a captured audio input signal; and
at least one controller being programmed to:
receive the captured audio input signal;
receive a first signal indicative of a vehicle speed for the vehicle;
determine a cutoff frequency based on the vehicle speed for the vehicle; and
apply the cutoff frequency to one or more filters to attenuate the captured audio input signal.

8. The audio system of claim 7, wherein the at least one controller is further programmed to apply the cutoff frequency to the one or more filters to filter the captured audio input signal.

9. The audio system of claim 8, wherein the at least one controller includes a look up table (LUT) that includes a plurality of vehicle speeds and a plurality of cutoff frequencies, wherein each of the plurality of vehicle speeds has an associated cutoff frequency to be applied to the one or more filters.

10. The audio system of any of claims 7 to 9, wherein the at least one controller is further programmed to determine an attenuation amount based on the vehicle speed for the vehicle.

11. The audio system of claim 10, wherein the at least one controller is further programmed to attenuate the captured audio input signal based on the attenuation amount to increase clarity of the captured audio input signal.

12. The audio system of claim 11, wherein the at least one controller includes a look up table (LUT) that includes a plurality of vehicle speeds and a plurality of attenuation amounts, wherein each of the plurality of vehicle speeds has an associated attenuation amount from the plurality of attenuation amounts.

13. The audio system of claim 11, wherein the at least one controller includes a gain block configured to have a gain adjusted thereof to attenuate the captured audio input signal based on the attenuation amount.

14. The audio system of any of claims 7 to 13, wherein the at least one controller is further programmed to transmit an audio output signal corresponding to the attenuated captured audio input signal to one or more loudspeakers positioned in the vehicle.

15. The audio system of any of claims 7 to 14, wherein the captured audio input signal corresponds to a captured audio signal that is external to the vehicle.
